# EUROPEAN PATENT APPLICATION

(11) **EP 4 773 173 A1**
(43) Date of publication of application: **08.07.2026**
(21) Application number: 24941993.8
(22) Date of filing: 29.08.2024
(51) Int. Cl.: H01L 21/66, H01L 21/67, G03F 1/84, G03F 1/72, G06T 7/00

(54) **METHOD FOR AUTOMATICALLY INSPECTING, CLASSIFYING, AND REMOVING DEFECT OF FLAT SUBSTRATE**

(30) Priority: 28.05.2024 KR 20240069270; 05.08.2024 KR 20240103960
(71) Applicant: Cowindst Co., Ltd., Pyeongtaek-si, Gyeonggi-do 17708 (KR)
(72) Inventor: KIM, Seon Joo, Anyang-si, Gyeonggi-do 14090 (KR); LEE, Jin Won, Hwaseong-si, Gyeonggi-do 18374 (KR); SEONG, Myung Jun, Incheon 21022 (KR); CHO, Deuk Ho, Uiwang-si, Gyeonggi-do 16103 (KR); KANG, Ho Yong, Anyang-si, Gyeonggi-do 13989 (KR); KIM, Hyoung Sik, Yongin-si, Gyeonggi-do 16910 (KR)
(74) Representative: Kim Kang, Jae Hee
(86) International application number: PCT/KR2024/096118
(87) International publication number: WO 2025/249686

(57) **Abstract**

There is provided a method for automatically inspecting, classifying, and removing defects of a flat substrate including a wafer or a mask, the method comprising: a first step of capturing, by a camera unit, an image of a surface of the flat substrate and inspecting a defect on the surface; a second step of automatically classifying the defect by determining, according to a preset criterion, whether the defect is removable and selecting one of a plurality of removal methods for the defect; a third step of, when the defect is of a removable type, moving a defect removal module to a target position at which the defect is located; a fourth step of removing the defect by selecting one unit within the defect removal module according to the removal method for the defect; and a fifth step of confirming whether the defect has been removed.

## Description

### TECHNICAL FIELD

The present invention particularly relates to a method in which an entire process of inspecting a flat substrate including a wafer or a mask, determining various defects on the flat substrate, classifying the defects based on the determination, and removing the defects is automatically performed.

### BACKGROUND ART

In general, optical inspection apparatuses are used to inspect defects in base materials such as semiconductor wafers. Conventionally, optical inspection of semiconductor wafers has been performed by comparing black-and-white images obtained by a monochrome camera. However, such a method makes it difficult to accurately determine various types of defects, thereby making automatic classification of defects difficult and reducing reliability of the inspection.

Further, when a defect is detected on a wafer, the defect may be removed using a cleaning apparatus. However, because such removal relies on manual operation by an operator, or otherwise results in the discarding of the wafer altogether, it causes problems such as reduced product yield and increased manufacturing costs may occur.

Further, from inspection of the wafer to classification and removal of defects according to the inspection results, an operator is unavoidably involved throughout the overall process, resulting in issues such as variations in productivity depending on the operator's skill level and the like, and labor consumption increase.

A similar situation also exists in the case of masks including photomasks.

### DETAILED DESCRIPTION OF THE INVENTION

### Technical Tasks

Embodiments of the present invention have been devised to solve the above-described problems, and an object of the present invention is to provide a method capable of automatically inspecting defects on a flat substrate including a wafer or a mask, automatically classifying the defects, and automatically removing the defects.

Another object of the present invention is to improve reliability of inspection results for the flat substrate through an algorithm capable of minimizing misclassification during an inspection step. Another object of the present invention is to allow defects to be accurately classified according to a preset criterion during a classification step. Another object of the present invention is to provide a module capable of selecting different methods according to the type of defect on the flat substrate during a removal step.

Another object of the present invention is to provide a module configured to prevent floating materials generated during a defect removal process from remaining on the flat substrate.

### Technical Solutions

In order to solve the above-described problems, an embodiment of the present invention provides a method for automatically inspecting, classifying, and removing defects of a flat substrate including a wafer or a mask, the method comprising: a first step of capturing, by a camera unit, an image of a surface of the flat substrate and inspecting a defect on the surface; a second step of automatically classifying the defect by determining, according to a preset criterion, whether the defect is removable and selecting one of a plurality of removal methods for the defect; a third step of, when the defect is of a removable type, moving a defect removal module to a target position at which the defect is located; a fourth step of removing the defect by selecting one unit within the defect removal module according to the removal method for the defect; and a fifth step of confirming whether the defect has been removed.

Preferably, the first step comprises inspecting the defect by comparing: (1) a reference image obtained by preprocessing an original image captured from the surface of the flat substrate; and (2) a comparison target image obtained by applying a color filter to a scan image generated by color-scanning the surface of the flat substrate so that a luminance difference is minimized.

Preferably, in the second step, the removal method is one of a first removal method in which gas is sprayed toward the target position and a surrounding region thereof, a second removal method in which a laser beam is irradiated onto the target position, and a third removal method in which the gas and the laser beam are used simultaneously, according to the type of defect.

Preferably, in the third step, the defect removal module comprises a cleaning unit configured to detach the defect by rapidly contracting and subsequently rapidly expanding the defect through physical collision of the gas with the defect (foreign material), corresponding to the first removal method.

Preferably, the third removal method comprises spraying the gas to cool the flat substrate while irradiating the laser beam to remove the defect.

Preferably, the method further comprises, between the fourth step and the fifth step, a step 4-1 of suctioning floating materials generated during the removal process of the defect.

Preferably, the floating materials are suctioned by a suction unit, and one side of the suction unit includes a suction portion recessed inwardly and having a circular cross section so that the floating materials are radially drawn into the suction portion.

### Effects of the Invention

According to the technical solutions of the present invention described above, various effects including the following may be obtained. However, the present invention is not limited to embodiments exhibiting all of the following effects.

According to an embodiment of the present invention, defects on a flat substrate including a wafer or a mask may be automatically inspected, automatically classified, and automatically removed.

Further, reliability of inspection results for the flat substrate including a wafer or a mask may be improved through an algorithm capable of minimizing misclassification during the inspection step. Further, defects may be accurately classified according to a preset criterion during the classification step. Further, different methods may be selected according to the type of defect on the flat substrate including a wafer or a mask during the removal step. Further, floating materials generated during the defect removal process may be prevented from remaining on the flat substrate including a wafer or a mask.

### BRIEF DESCRIPTION OF THE DRAWINGS

FIG. 1 is a flowchart illustrating a method for automatically inspecting, classifying, and removing defects of a flat substrate according to an embodiment of the present invention.
FIG. 2 is a view schematically illustrating a process of generating a comparison target image in which a luminance difference is minimized in FIG. 1.
FIG. 3 is a schematic view illustrating a defect removal module according to an embodiment of the present invention.
FIG. 4 is an enlarged schematic view of a lower portion of FIG. 3.
FIG. 5 is a schematic view illustrating an operating manner of the laser unit of FIG. 3.
FIG. 6 is a schematic view illustrating an operating manner of the cleaning unit of FIG. 3.
FIG. 7 is a schematic top view of FIG. 4.

### EMBODIMENTS FOR IMPLEMENTING THE INVENTION

In order to facilitate a sufficient understanding of the configurations and advantages of the present disclosure, preferred embodiments of the present disclosure will be described with reference to the accompanying drawings. However, the present disclosure is not limited to the embodiments disclosed herein and may be embodied in various forms with various modifications. In the following description of the present invention, detailed descriptions of well-known functions and configurations will be omitted when it is determined that they may unnecessarily obscure the gist of the present invention to the person skilled in the art.

Terms such as "first," "second," and the like may be used herein to describe various elements, but such elements should not be limited by these terms. These terms are used merely to distinguish one element from another. For example, without departing from the scope of the present disclosure, a first element may be referred to as a second element, and similarly a second element may be referred to as a first element.

As used herein, terms such as "comprise," "include," or the like are intended to specify the presence of stated features, numbers, steps, operations, elements, components, parts, or combinations thereof, but do not preclude the presence or addition of one or more other features, numbers, steps, operations, elements, components, parts, or combinations thereof.

Terms used herein are used only for the purpose of describing particular embodiments and are not intended to limit the present invention. Unless the context clearly indicates otherwise, singular forms include plural forms as well. Unless otherwise defined, terms used in the embodiments of the present disclosure should be interpreted as having meanings commonly understood by those skilled in the art to which the present disclosure pertains.

Hereinafter, specific embodiments of the present invention will be described in detail with reference to the drawings.

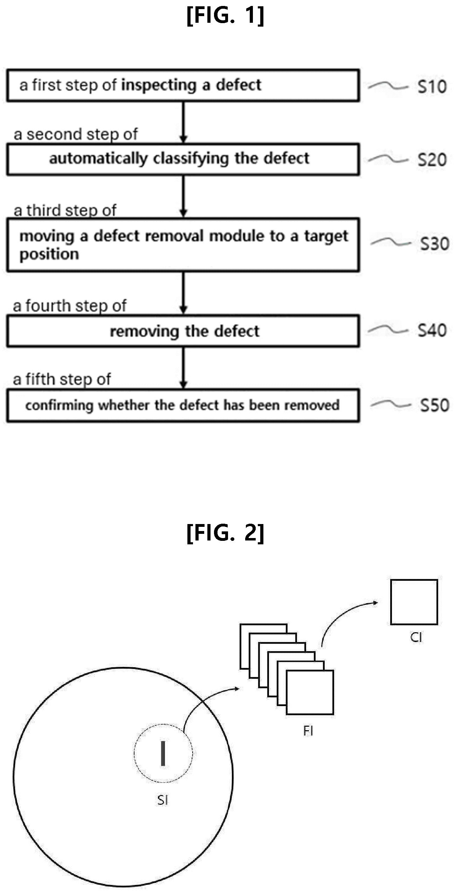

FIG. 1 is a flowchart illustrating a method for automatically inspecting, classifying, and removing defects of a flat substrate including a wafer or a mask according to an embodiment of the present invention. Referring to FIG. 1, the method for automatically inspecting, classifying, and removing defects of a flat substrate W including a wafer or a mask according to an embodiment of the present invention may include first to fifth steps S10 to S50. Here, the first to fifth steps may be automatically performed.

The first step is a step of capturing, by a camera unit 100, an image of a surface of the flat substrate W including a wafer or a mask and inspecting a defect. (S10) In one embodiment, the flat substrate W including a wafer or a mask is merely one example of an inspection target, and, if the practical use thereof is an inspection substrate, the material thereof is not limited and may be glass, metal, or the like. The mask includes a photomask and the like. Before the first step, the flat substrate W including a wafer or a mask may undergo loading, alignment, and the like.

FIG. 2 is a view schematically illustrating a process of generating a comparison target image in which a luminance difference is minimized in FIG. 1. Referring to FIG. 2, more specifically, the first step may inspect the defect by comparing: (1) a reference image obtained by preprocessing an original image captured from the surface of the flat substrate W including a wafer or a mask; and (2) a comparison target image CI obtained by applying a color filter to a scan image SI generated by color-scanning the surface of the flat substrate W including a wafer or a mask so that a luminance difference is minimized.

Here, the original image refers to a color image captured from a normal flat substrate W including a wafer or a mask. The preprocessing is image preprocessing and may be performed on some or all of at least one original image randomly selected. Further, the image preprocessing may be the same process as a process of converting the scan image SI into the comparison target image CI.

The scan image SI refers to a color image captured from the flat substrate W including a wafer or a mask as an inspection target, that is, a color image including a defect. The color filter may include, for example, an R (red) filter, a G (green) filter, a B (blue) filter, an H (hue) filter, an S (saturation) filter, and a V (value) filter. The scan image SI may be first converted into filter images FI obtained by respectively applying the R, G, B, H, S, and V filters. In this case, the filter images FI are black-and-white images. Next, the filter images FI may be secondarily converted into equalized images each having visually improved brightness by a preset histogram equalization algorithm. Thereafter, the comparison target image CI may be generated from any one of the six equalized images or from a combination of at least two of the six equalized images according to a preset algorithm.

That is, in the first step, a black-and-white image having no luminance difference or a minimized luminance difference is generated from a color image generated through the camera unit 100, and the resulting images are compared with each other, whereby a defect on the flat substrate W including a wafer or a mask, which is an inspection target, may be automatically detected.

The second step is a step of automatically classifying the defect by determining, according to a preset criterion, whether the defect is removable and selecting one of a plurality of removal methods for the defect. (S20)

Referring to Table 1 below, defects may be classified into a plurality of types. The defect may include a bump B, a foreign material C, discoloration, and the like on the surface of the flat substrate W including a wafer or a mask. The foreign material C may include metallic foreign material, organic foreign material, and the like. In this case, the defect may be automatically classified into one of the plurality of types according to a preset criterion. Further, whether the classified defect is removable may be automatically determined according to a preset criterion. In addition, a removal method for the classified defect may be automatically determined according to a preset criterion.

**[Table 1]**

| Defect Type | Removability | Removal Method |
|---|---|---|
| Missing Pattern (Bump) | Impossible | - |
| Defect Type | Removability | Removal Method |
| Scratch | Impossible | - |
| Foreign Material | Possible | Third Removal Method |
| PR Residue | Possible | Second Removal Method |
| Unformed Pattern (Bump) | Impossible | - |
| Pattern (Bump) dent | Impossible | - |
| Lump / Nodule | Impossible | - |
| Bump Discolor | Possible | Third Removal Method |
| Raw Material | Possible | First Removal Method |
| Metal Corrosion | Possible | Second Removal Method |
| Pitting | Impossible | - |
| Pattern (Bump) Misalign | Impossible | - |
| Big Pattern (Bump) | Impossible | - |
| Bridged Pattern (Bump) (Short) | Impossible | - |
| Missing Pattern (Bump) | Impossible | - |
| Passivation Damage | Possible | First Removal Method |
| UBM Residue | Possible | First Removal Method |
| Scratch | Impossible | - |
| Parasitic Bump | Possible | First Removal Method |
| Foreign Material | Possible | Third Removal Method |
| Small Bump | Impossible | - |
| Unformed Bump | Impossible | - |
| Pattern (Ball) Abnormal | Impossible | - |
| Passivation Discolor | Possible | First Removal Method |
| RDL Discolor | Possible | First Removal Method |
| Defect Type | Removability | Removal Method |
| PSV Wrinkle | Possible | First Removal Method |
| RDL Open | Impossible | - |
| Pattern (Bump) Discolor | Impossible | First Removal Method |

In one embodiment, removability may be classified, for example, as possible or impossible. Further, the removal method may be classified as one of the first to third removal methods according to the type of defect. First, the first removal method is a method of removing the defect by spraying gas toward the target position and a surrounding region thereof. The second removal method is a method of removing the defect by irradiating a laser beam L onto the target position. The third removal method is a method of removing the defect by using the gas and the laser beam L simultaneously. Here, the target position means a position of the defect existing on the surface of the flat substrate W including a wafer or a mask.

Meanwhile, when the defect is determined to be impossible to remove, the defect may skip the removal step or may be removed through a manual removal process performed by an operator rather than through automatic removal based on a preset algorithm.

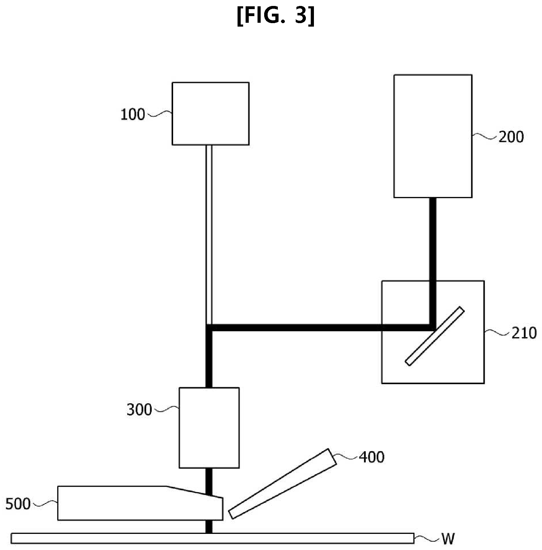

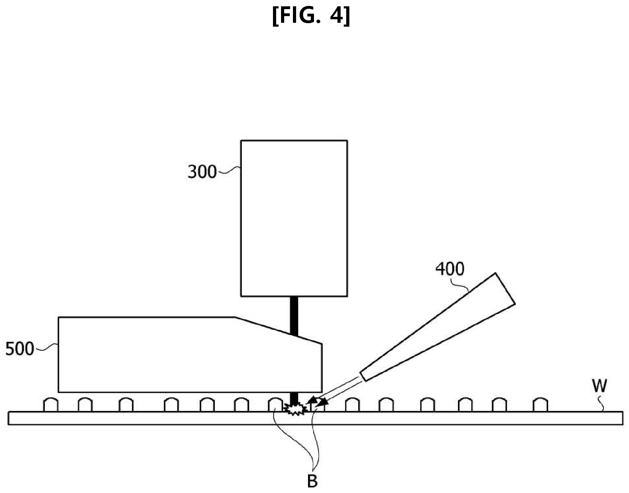

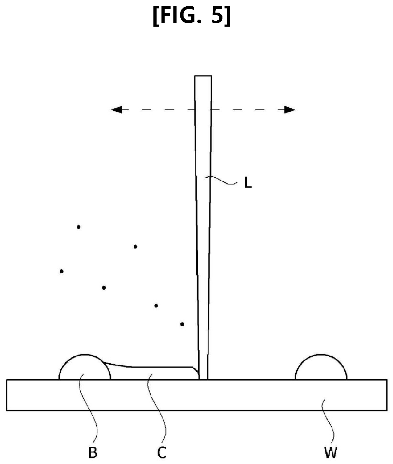

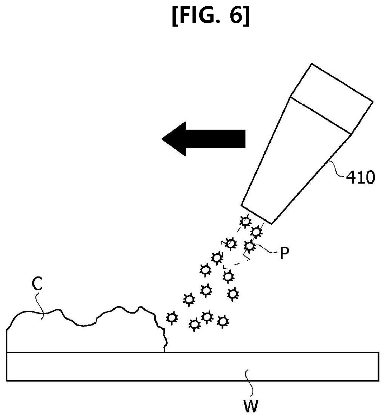

FIG. 3 is a schematic view illustrating a defect removal module according to an embodiment of the present invention, FIG. 4 is an enlarged schematic view of a lower portion of FIG. 3, FIG. 5 is a schematic view illustrating an operating manner of the laser unit of FIG. 3, and FIG. 6 is a schematic view illustrating an operating manner of the cleaning unit of FIG. 3.

The third step is a step of moving a defect removal module to a target position at which the defect is located when the defect is of a removable type. (S30) Here, the defect removal module constitutes a portion of a cleaning apparatus. The defect removal module may be moved to the target position by, for example, a movement unit (not shown). The movement unit may move the defect removal module to corresponding coordinates based on address data including coordinates of the target position. In addition, the cleaning apparatus according to one embodiment may include the above-described camera unit 100.

Meanwhile, the defect removal module may include a cleaning unit 400, a laser unit 200, a suction unit 500, and the like. The cleaning unit 400 corresponds to the first removal method and detaches the defect (including foreign material) through a process in which the defect rapidly contracts and subsequently rapidly expands due to physical collision of gas with the defect (including foreign material).

The cleaning unit 400 may include an injection nozzle 410 configured to spray gas. In one embodiment, the cleaning unit may spray gas toward the target position and a surrounding region thereof. Here, the gas may be a cooling gas. In one embodiment, the cooling gas is sprayed at high pressure and may include solid-state CO2 pellets. Further, the CO2 pellets P are preferably solid-state carbon dioxide (dry ice) formed to have a size on the order of several micrometers to several tens of micrometers.

More specifically, in the detachment process of the defect (foreign material) CO2 pellets P having a temperature in a range of -70°C to -80°C freeze the defect (foreign material) while colliding with the defect (foreign material). During that process, cracks are generated as the defect (foreign material) rapidly contracts due to a temperature difference with the surroundings. At this time, the CO2 pellets P sprayed at a high speed may partially enter gaps between the cracks of the defect (foreign material). Alternatively, the CO2 pellets P may partially enter a gap between the defect (foreign material) and the flat substrate W including a wafer or a mask. The CO2 pellets P that enter the defect (foreign material) are sublimated and, in one embodiment, may expand in volume by 800 times or more.

Meanwhile, since the CO2 pellets P sublimate into gas at room temperature, secondary contamination caused by the cooling gas itself may be prevented. As the CO2 pellets P expand, the defect (foreign material) may be broken by an expansion force or separated from the surface of the flat substrate W including a wafer or a mask. The cleaning unit 400 may repeat this process to remove the defect (foreign material) attached to the surface of the flat substrate W including a wafer or a mask. Meanwhile, floating materials may be generated during the process of removing the defect (foreign material) by the cleaning unit 400.

The laser unit 200 corresponds to the second removal method and removes the defect (including foreign material) by irradiating a laser beam L onto the target position at which the defect (including foreign material) is attached. The laser unit 200 generates a laser beam L having a preset wavelength, pulse width, and output conditions. The laser unit 200 may generate a single-pulse laser beam L or a multi-pulse laser beam L. Further, the laser beam L may be appropriately selected according to the defect. In addition, the laser scanner portion 210 may adjust an optical axis of the laser beam L such that the laser beam L is irradiated onto a preset position. Meanwhile, floating materials may be generated during a process of removing the defect (foreign material) using the laser beam L.

The third removal method is a method of removing the defect by irradiating the laser beam L while spraying gas to cool the flat substrate W including a wafer or a mask. In this method, the cleaning unit 400 and the laser unit 200 are used together.

According to one embodiment of the present invention, during a process of removing the defect (foreign material) by the laser unit 200, the cleaning unit 400 may be configured to spray solid-state carbon dioxide to cool the flat substrate W including a wafer or a mask and to simultaneously blow away floating materials generated during the defect (foreign material) removal process while preventing thermal damage to the flat substrate W including a wafer or a mask.

That is, during the defect (foreign material) removal process by the laser unit 200, the cleaning unit 400 may be operated simultaneously. In one embodiment, it has been confirmed through internal experiments that the above-described CO2 pellets P may be used as both a cooling gas and a blowing gas.

The fourth step is a step of removing the defect by selecting one unit within the defect removal module according to the removal method for the defect. (S40) In one embodiment, one unit may be selected according to the first to third removal methods. In the case of the first removal method, the cleaning unit 400 is selected. In the case of the second removal method, the laser unit 200 is selected. In the case of the third removal method, the cleaning unit 400 and the laser unit 200 may be selected.

The fifth step is a step of confirming whether the defect has been removed. (S50) This may be performed, for example, only for a defect determined to be removable. The fifth step may be automatically performed through the camera unit 100.

Meanwhile, the method may further include, between the fourth step and the fifth step, a 4-1 step of suctioning floating materials generated during the removal process of the defect (foreign material). In one embodiment, the suction unit 500 may suction floating materials generated by the laser unit 200 and/or the cleaning unit 400. In this case, the suction unit 500 may be operated simultaneously with the laser unit 200 and/or the cleaning unit 400 so that the floating materials are prevented from being reattached to the surface of the flat substrate W including a wafer or a mask. In this case, the suction unit 500 may be disposed between an objective lens unit 300 and the flat substrate W including a wafer or a mask. Meanwhile, the suction unit 500 may include a suction portion 510 configured to suction air at the target position and a surrounding region thereof. In one embodiment, the suction portion 510 may be formed on one side of the suction unit 500.

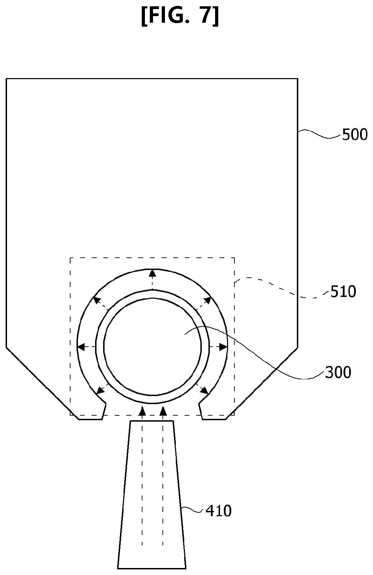

FIG. 7 is a schematic top view of FIG. 4. Referring to FIG. 7, the suction portion 510 may be recessed inwardly of the suction unit 500 and may have a circular cross section so that floating materials are radially drawn into the suction portion. Such a suction portion 510 may improve suction performance by causing an isotropic flow of the floating materials.

Meanwhile, the inner diameter of the suction portion 510 means an inner diameter of a circular shape defined by the cross section of the suction portion 510. In one embodiment, the target position may be located within the inner diameter of the suction portion 510. That is, the center of the inner diameter of the suction portion 510 may be disposed on an optical axis of the objective lens unit 300 or on an optical path of the objective lens unit 300. Alternatively, the center of the inner diameter of the suction portion 510 may be disposed on an optical path of the camera unit 100. In one embodiment, the inner diameter of the suction portion 510 (a second diameter) is preferably equal to or greater than an outer diameter of the objective lens unit 300 (a first diameter).

Referring again to FIG. 7, the cleaning unit 400 may be disposed to face the suction portion 510 and may be configured to spray carbon dioxide in a dry-ice state toward the suction portion 510 during operation of the suction unit 500. For example, the cleaning unit 400 may be disposed at one open side of the suction portion 510. In this case, the cleaning unit 400 may generate anisotropic airflow such that floating materials are guided toward the suction portion 510.

Further, as described above, the cleaning unit 400 may cool the surface of the flat substrate W including a wafer or a mask during the defect (foreign material) removal process by the laser unit 200 through spraying of the cooling gas. For example, the cooling gas sprayed by the cleaning unit 400 may be reflected from the surface of the flat substrate W including a wafer or a mask and guided toward the suction portion 510.

While preferred embodiments of the present invention have been described above, the present invention is not limited to the embodiments disclosed herein, and various modifications may be made without departing from the scope of the appended claims.

## Claims

1. A method for automatically inspecting, classifying, and removing defects of a flat substrate including a wafer or a mask, the method comprising:
a first step of capturing, by a camera unit, an image of a surface of the flat substrate and inspecting a defect on the surface;
a second step of automatically classifying the defect by determining, according to a preset criterion, whether the defect is removable and selecting one of a plurality of removal methods for the defect;
a third step of, when the defect is of a removable type, moving a defect removal module to a target position at which the defect is located;
a fourth step of removing the defect by selecting one unit within the defect removal module according to the removal method for the defect; and
a fifth step of confirming whether the defect has been removed.

2. The method of claim 1,
wherein the first step comprises inspecting the defect by comparing:
a reference image obtained by preprocessing an original image captured from the surface of the flat substrate; and
a comparison target image obtained by applying a color filter to a scan image generated by color-scanning the surface of the flat substrate so that a luminance difference is minimized.

3. The method of claim 1,
wherein, in the second step, the removal method comprises, according to the type of defect, one of:
a first removal method in which gas is sprayed toward the target position and a surrounding region thereof;
a second removal method in which a laser beam is irradiated onto the target position; and
a third removal method in which the gas and the laser beam are used simultaneously.

4. The method of claim 3,
wherein, in the third step, the defect removal module comprises a cleaning unit, corresponding to the first removal method, configured to detach the defect by rapidly contracting and subsequently rapidly expanding the defect through physical collision of the gas with the defect (foreign material).

5. The method of claim 3,
wherein the third removal method comprises spraying the gas to cool the flat substrate while irradiating the laser beam to remove the defect.

6. The method of claim 1, further comprising, between the fourth step and the fifth step, a step 4-1 of suctioning floating materials generated during a removal process of the defect.

7. The method of claim 6,
wherein the floating materials are suctioned by a suction unit, and
wherein one side of the suction unit includes a suction portion recessed inwardly and having a circular cross section so that the floating materials are radially drawn into the suction portion.
